# EUROPÄISCHE PATENTANMELDUNG

(11) **EP 2 509 127 A1**
(43) Veröffentlichungstag der Anmeldung: **10.10.2012**
(21) Anmeldenummer: 11161509.2
(22) Anmeldetag: 07.04.2011
(51) Int. Cl.: H01L 41/113, H01L 41/193, H01L 41/26, C08G 18/10, C08G 18/42, C08G 18/66

(54) **Verwendung von thermoplastischen Polyurethanen zur Wandlung von mechanischer Energie in elektrische Energie**

(71) Anmelder: Bayer Material Science AG, 51368 Leverkusen (DE)
(72) Erfinder: Jenninger, Werner, Verstorben (FR); Wagner, Joachim, 51061 Köln (DE); Bräuer, Wolfgang, 51375 Leverkusen (DE); Schapeler, Dirk, 94040-0000 Mountain View (US)

(57) **Zusammenfassung**

Vorgestellt wird ein Verfahren zur Gewinnung von elektrischer Energie aus Bewegungsenergie mit einer Vorrichtung, die ein elektroaktives Polymer umfasst. Weiterhin wird die Verwendung eines thermoplastischen Polyurethans zur Gewinnung von elektrischer Energie aus Bewegungsenergie, als Aktuatormaterial und/oder Sensormaterial, einen Aktuator und/oder Sensor, umfassend ein thermoplastisches Polyurethan sowie eine Vorrichtung zur Gewinnung von elektrischer Energie aus Bewegungsenergie, wobei die Vorrichtung ein elektroaktives Polymer umfasst, vorgestellt. Das elektroaktive Polymer umfasst jeweils ein thermoplastisches Polyurethan, das erhältlich ist aus der Reaktion von wenigstens:
(a) einem oder mehreren linearen, bifunktionellen und hydroxylterminierten Polyolen mit einem zahlenmittleren Molekulargewicht Mₙ von ≥ 500 g/mol bis ≤ 6000 g/mol;
(b) einem oder mehreren Diol-Kettenverlängerern mit einem zahlenmittleren Molekulargewicht Mₙ von ≥ 60 g/mol bis ≤ 400 g/mol; und
(c) einem oder mehreren organischen Diisocyanaten;
wobei das molare Verhältnis von NCO-Gruppen in (c) zu OH-Gruppen in (a) und (b) ≥ 0,9:1 bis ≤ 1,1:1 beträgt.

## Beschreibung

Die vorliegende Erfindung betrifft ein Verfahren zur Gewinnung von elektrischer Energie aus Bewegungsenergie, umfassend die Schritte des Bereitstellens einer Vorrichtung, wobei die Vorrichtung ein elektroaktives Polymer umfasst, des Dehnens des elektroaktiven Polymers von einer minimalen Dehnung bis zu einer maximalen Dehnung als Folge einer mechanischen Einwirkung und des Relaxierens des gedehnten elektroaktiven Polymers von der maximalen Dehnung bis zu der minimalen Dehnung als Folge einer nachlassenden mechanischen Einwirkung. Die vorliegende Erfindung betrifft nicht die Gewinnung von elektrischer Energie aus der Bewegungsenergie von Meereswellen.

Die Erfindung betrifft weiterhin die Verwendung eines thermoplastischen Polyurethans zur Gewinnung von elektrischer Energie aus Bewegungsenergie, als Aktuatormaterial und/oder Sensormaterial, einen Aktuator und/oder Sensor, umfassend ein thermoplastisches Polyurethan sowie eine Vorrichtung zur Gewinnung von elektrischer Energie aus Bewegungsenergie, wobei die Vorrichtung ein elektroaktives Polymer umfasst.

Die Energiegewinnung aus Bewegungsenergie mittels elektroaktiven Polymergeneratoren (EAP-Generatoren) basiert auf dem Prinzip der Umwandlung von mechanischer Energie in eine Dehnung des EAP-Generators in einer ersten Stufe, die dann unter Verwendung eines Energiegewinnungszyklus (Energy Harvesting Cycle, EHC) schließlich in elektrische Energie umgewandelt wird.

Beispiele für elektromechanische Wandler finden sich in WO 2001/06575 A1. Diese Patentanmeldung betrifft Wandler, ihre Verwendung und ihre Herstellung. Solch ein Wandler zur Umwandlung von mechanischer Energie in elektrische Energie umfasst wenigstens zwei Elektroden und ein Polymer. Das Polymer ist so angeordnet, dass als Folge einer Längenänderung eines ersten Abschnittes ein elektrisches Feld verändert wird. Weiterhin ist ein zweiter Abschnitt des Polymers elastisch vorgespannt.

Eine der Möglichkeiten, um die Energiegewinnung zu verbessern, ist die Veränderung des Materials des elektroaktiven Polymers.

US 5,877,685 erwähnt einen Polyurethanelastomer-Aktuator, der ein Polyurethanelastomer umfasst, welches als Folge einer Orientierung durch ein elektrisches Feld deformierbar ist. Die Schrumpfauslenkung zum Zeitpunkt des Anlegens eines elektrischen Feldes wird in eine andere Auslenkung überführt. Dieser Polyurethanelastomer-Aktuator benötigt keinen Elektrolyten und keine hohe Spannung. Da keine chemischen Reaktionen oder Wärmeentwicklung auftreten, verschlechtere sich die Lebensdauer kaum. Der beschriebene Aktuator verformt sich in großem Maße während des Ansteuerns.

JP 3026043 betrifft einen Polyurethanelastomer-Aktuator auf der Basis eines dielektrischen Polyols. Dieses Polyol ist in Feldrichtung orientiert, wenn ein elektrisches Feld angelegt wird.

JP 07-240544 betrifft einen Polyurethanelastomer-Aktuator auf der Basis eines Polycarbonat-Polyols. Dieses Polyol ist in Feldrichtung orientiert, wenn ein elektrisches Feld angelegt wird.

Thermoplastische Polyurethan-Elastomere (TPU) sind seit langem bekannt. Sie sind von technischer Bedeutung aufgrund der Kombination hochwertiger mechanischer Eigenschaften mit den bekannten Vorteilen der kostengünstigen thermoplastischen Verarbeitbarkeit. Durch die Verwendung unterschiedlicher chemischer Aufbaukomponenten lässt sich eine große Variationsbreite mechanischer Eigenschaften erzielen. Eine Übersicht über thermoplastische Polyurethan-Elastomere, ihre Eigenschaften und Anwendungen wird zum Beispiel in Kunststoffe 68 (1978), Seiten 819 bis 825 oder Kautschuk, Gummi, Kunststoffe 35 (1982), Seiten 568 bis 584 gegeben.

Thermoplastische Polyurethan-Elastomere werden aus linearen Polyolen, meist Polyester- oder Polyether-Polyolen, organischen Diisocyanaten und kurzkettigen Diolen (Kettenverlängerern) aufgebaut. Zur Beschleunigung der Bildungsreaktion können zusätzlich Katalysatoren zugesetzt werden. Zur Einstellung der Eigenschaften können die Aufbaukomponenten in relativ breiten molaren Verhältnissen variiert werden. Bewährt haben sich molare Verhältnisse von Polyolen zu Kettenverlängerern von 1:1 bis 1:12. Hierdurch ergeben sich Produkte mit Härten im Bereich von 70 Shore A bis 75 Shore D.

Die thermoplastischen Polyurethan-Elastomere können kontinuierlich oder diskontinuierlich verarbeitet werden. Die bekanntesten technischen Verfahren sind das Bandverfahren (GB 1,057,018) und das Extruderverfahren (DE 1 964 834 und 2 059 570).

Die für ein verbessertes Verarbeitungsverhalten geeignete Morphologie wird bei den Produkten, die nach üblichen Verfahren hergestellt werden, erst bei hohen Hartsegmentanteilen (Kettenverlängerer + Diisocyanat) erreicht. Dadurch wird die Beweglichkeit des Weichsegmentes (Polyol + Diisocyanat) so eingeschränkt, dass die Kälteflexibilität und das Fließverhalten verschlechtert werden. Außerdem erhöht man gleichzeitig den Härtegrad des Produktes.

Die Veränderung der Morphologie durch Erhöhung des Molgewichtes des Polyols führt zu einer stärkeren Phasenentmischung und verbesserten mechanischen Werten, aber durch die gleichzeitige Herabsetzung des Hartsegmentanteils zu einer deutlichen Verminderung der Härte (Seefried u.a., J.Appl. Pol. Sci. 19, 2493, 1975). Von einem verbesserten Rekristallisationsverhalten wird deshalb nicht berichtet.

Die vorliegende Erfindung hat sich die Aufgabe gestellt, ein eingangs genanntes Verfahren zur Energiegewinnung hinsichtlich des eingesetzten Polymermaterials durch die Angabe von besser geeigneten Materialien zu verbessern.

Die Aufgabe wird erfindungsgemäß gelöst durch ein Verfahren zur Gewinnung von elektrischer Energie aus Bewegungsenergie, umfassend die Schritte:
Bereitstellen einer Vorrichtung,
   wobei die Vorrichtung ein elektroaktives Polymer umfasst, welches zwischen Elektroden angeordnet ist und
   wobei in der Vorrichtung mechanische Energie auf das elektroaktive Polymer übertragen wird;
Dehnen des elektroaktiven Polymers von einer minimalen Dehnung bis zu einer maximalen Dehnung als Folge einer mechanischen Einwirkung,
   wobei im gedehnten Zustand des elektroaktiven Polymers dieses mit einer elektrischen Zielladung beaufschlagt wird, bei der die elektrische Durchbruchsfeldstärke des elektroaktiven Polymers nicht überschritten wird; und
Relaxieren des gedehnten elektroaktiven Polymers von der maximalen Dehnung bis zu der minimalen Dehnung als Folge einer nachlassenden mechanischen Einwirkung,
   wobei während des Relaxierens des elektroaktiven Polymers dieses bis auf eine Restladung entladen wird;
wobei sich das Verfahren dadurch auszeichnet, dass
das elektroaktive Polymer ein thermoplastisches Polyurethan umfasst, das erhältlich ist aus der Reaktion von wenigstens:
(a) einem linearen, bifunktionellen und hydroxylterminierten Polyol mit einem zahlenmittleren Molekulargewicht Mₙ von ≥ 500 g/mol bis ≤ 6000 g/mol;
(b) einem Diol-Kettenverlängerer mit einem zahlenmittleren Molekulargewicht Mₙ von≥ 60 g/mol bis ≤ 400 g/mol; und
(c) einem organischen Diisocyanat;
wobei das molare Verhältnis von NCO-Gruppen in (c) zu OH-Gruppen in (a) und (b) ≥ 0,9:1 bis ≤ 1,1:1 beträgt.

Elektroaktive Polymere (EAP) im Sinne der vorliegenden Erfindung sind grundsätzlich Polymere, die durch das Anlegen einer elektrischen Spannung ihre Form ändern und insbesondere dielektrische Elastomere. Das elektroaktive Polymer ist zwischen Elektroden angeordnet, welche ebenfalls dehnbar sein können.

Die vorgeschlagenen thermoplastischen Polyurethane zeichnen sich durch eine besonders günstige Kombination des E-Moduls, des elektrischen Widerstands und der Durchbruchfeldstärke aus. Dieses wirkt sich günstig auf die Effizienz der Energiegewinnung aus.

Im erfindungsgemäßen Verfahren kann das gedehnte elektroaktive Polymer mittels einer geeigneten Einheit, welche beispielsweise als Leistungselektronik oder Ladeelektronik bezeichnet werden kann, mit einer elektrischen Ladung beaufschlagt werden. Beim Relaxieren oder Entspannen wird diese Ladung wieder entnommen, wodurch elektrische Energie gewonnen wird.

Lineare bifunktionelle Polyhydroxylverbindungen oder Polyole (a) sind solche mit im Mittel > 1,8 bis ≤ 2,2 Zerewitinoff-aktiven Wasserstoffatomen und einem zahlenmittleren Molekulargewicht Mₙ von ≥ 500 g/mol bis ≤ 6000 g/mol, bevorzugt ≥900 g/mol bis ≤ 2500 g/mol. Produktionsbedingt können sie kleine Mengen an nicht-linearen Verbindungen enthalten. Dieses ist jedoch erfindungsgemäß mit eingeschlossen. Bevorzugt sind Polyether-, Polyester-, Polycarbonat-Diole oder Gemische aus diesen.

Das zahlenmittlere Molekulargewicht Mₙ wird durch Gelpermeationschromatographie (GPC) in Tetrahydrofuran bestimmt, wobei als Kalibierbeziehung Polystyrol-Standards im relevanten Molekulargewichtsbereich verwendet werden.

Geeignete Polyether-Diole können dadurch hergestellt werden, dass man ein oder mehrere Alkylenoxide mit 2 bis 4 Kohlenstoffatomen im Alkylenrest mit einem Startermolekül, das zwei aktive Wasserstoffatome gebunden enthält, umsetzt. Als Alkylenoxide seien zum Beispiel genannt: Ethylenoxid, 1,2-Propylenoxid, Epichlorhydrin und 1,2- Butylenoxid und 2,3-Butylenoxid. Vorzugsweise Anwendung finden Ethylenoxid, Propylenoxid und Mischungen aus 1,2-Propylenoxid und Ethylenoxid. Die Alkylenoxide können einzeln, alternierend nacheinander oder als Mischungen verwendet werden. Als Startermoleküle kommen beispielsweise in Betracht: Wasser, Aminoalkohole, wie N-Alkyl-diethanolamine, beispielsweise N-Methyl-diethanolamin und Diole wie Ethylenglykol, 1,3-Propylenglykol, 1,4-Butandiol und 1,6 Hexandiol. Gegebenenfalls können auch Mischungen von Startermolekülen eingesetzt werden. Geeignete Polyetherole sind ferner die hydroxylgruppenhaltigen Polymerisationsprodukte des Tetrahydrofurans. Es können auch trifunktionelle Polyether in Anteilen von 0 bis 30 Gewichts-%, bezogen auf die bifunktionellen Polyether, zusätzlich eingesetzt werden, jedoch höchstens in solcher Menge, dass ein noch thermoplastisch verarbeitbares Produkt entsteht.

Geeignete Polyester-Diole können beispielsweise aus Dicarbonsäuren mit 2 bis 12 Kohlenstoffatomen, vorzugsweise 4 bis 6 Kohlenstoffatomen, und mehrwertigen Alkoholen hergestellt werden. Als Dicarbonsäuren kommen beispielsweise in Betracht: aliphatische Dicarbonsäuren wie Bernsteinsäure, Glutarsäure, Adipinsäure, Korksäure, Azelainsäure und Sebacinsäure, oder aromatische Dicarbonsäuren, wie Phthalsäure, Isophthalsäure und Terephthalsäure. Die Dicarbonsäuren können einzeln oder als Gemische, zum Beispiel in Form einer Bernstein-, Glutar- und Adipinsäuremischung, verwendet werden. Zur Herstellung der Polyester-Diole kann es gegebenenfalls vorteilhaft sein, anstelle der Dicarbonsäuren die entsprechenden Dicarbonsäurederivate, wie Carbonsäurediester mit 1 bis 4 Kohlenstoffatomen im Alkoholrest, Carbonsäureanhydride oder Carbonsäurechloride zu verwenden. Beispiele für mehrwertige Alkohole sind Glykole mit 2 bis 10, vorzugsweise 2 bis 6 Kohlenstoffatomen wie Ethylenglykol, Diethylenglykol, 1,4-Butandiol, 1,5-Pentandiol, 1,6 Hexandiol, 1,10-Decandiol, 2,2-Dimethyl-1,3-propandiol, 1,3-Propandiol oder Dipropylenglykol. Je nach den gewünschten Eigenschaften können die mehrwertigen Alkohole allein oder in Mischung untereinander verwendet werden. Geeignet sind ferner Ester der Kohlensäure mit den genannten Diolen, insbesondere solchen mit 4 bis 6 Kohlenstoffatomen, wie 1,4-Butan-diol oder 1,6-Hexandiol, Kondensationsprodukte von ω-Hydroxycarbonsäuren wie ω-Hydroxycapronsäure oder Polymerisationsprodukte von Lactonen, zum Beispiel gegebenenfalls substituierten ω-Caprolactonen. Als Polyester-Diole vorzugsweise verwendet werden Ethandiol-polyadipate, 1,4-Butandiolpolyadipate, Ethandiol-1,4-butandiolpolyadipate, 1,6-Hexandiol-neopentylglykolpolyadipate, 1,6-Hexandiol-1,4-butandiolpolyadipate und Polycaprolactone.

Diol-Kettenverlängerungsmittel (b) besitzen im Mittel 1,8 bis 2,2 Zerewitinoff-aktive Wasserstoffatome und haben ein Molekulargewicht Mₙ von≥ 60 g/mol bis ≤ 400 g/mol.

Als Kettenverlängerungsmittel werden vorzugsweise aliphatische Diole mit 2 bis 14 Kohlenstoffatomen eingesetzt wie Ethandiol, 1,2-Propandiol, 1,3-Propandiol, 1,4-Butandiol, 2,3-Butandiol, 1,5-Pentandiol, 1,6-Hexandiol, Diethylenglykol und Dipropylenglykol. Geeignet sind jedoch auch Diester der Terephthalsäure mit Glykolen mit 2 bis 4 Kohlenstoffatomen, zum Beispiel Terephthalsäure-bis-ethylenglykol oder Terephthalsäure-bis-1,4-butandiol, Hydroxyalkylenether des Hydrochinons, zum Beispiel 1,4-Di(β-hydroxyethyl)-hydrochinon, ethoxylierte Bisphenole wie 1,4-Di(β-hydroxyethyl)-bisphenol A. Besonders bevorzugt werden als Kettenverlängerer Ethandiol, 1,4-Butandiol, 1,6-Hexandiol, 1,4-Di(β-hydroxyethyl)-hydrochinon oder 1,4 Di(β-hydroxyethyl)-bisphenol A verwendet. Es können auch Gemische der oben genannten Kettenverlängerer eingesetzt werden. Daneben können auch kleinere Mengen an Triolen zugesetzt werden

Es ist ebenfalls möglich, dass zusätzlich Kettenverlängerungsmittel mit Aminogruppen, Thiolgruppen oder Carboxylgruppen aufweisenden Verbindungen eingesetzt werden. Beispielsweise können (cyclo)aliphatische Diamine wie Isophorondiamin, Ethylendiamin, 1,2-Propylendiamin, 1,3-Propylendiamin, N Methyl-propylen-1,3-diamin, N,N'-Dimethylethylendiamin und aromatische Diamine, wie 2,4-Toluylendiamin, 2,6-Toluylendiamin, 3,5-Diethyl-2,4 toluylendiamin oder 3,5 Diethyl-2,6-toluylendiamin oder primäre mono-, di-, tri- oder tetraalkylsubstituierte 4,4'-Diaminodiphenylmethane Verwendung finden.

Als organische Diisocyanate (c) können aliphatische, cycloaliphatische, araliphatische, aromatische und heterocyclische Diisocyanate oder beliebige Gemische dieser Diisocyanate verwendet werden (vgl. HOUBEN-WEYL "Methoden der organischen Chemie", Band E20 "Makromolekulare Stoffe", Georg Thieme Verlag, Stuttgart, New York 1987, S. 1587-1593 oder Justus Liebigs Annalen der Chemie, 562, Seiten 75 bis 136).

Im einzelnen seien beispielhaft genannt: aliphatische Diisocyanate wie Ethylendiisocyanat, 1,4-Tetramethylendiisocyanat, 1,6-Hexamethylendiisocyanat, 1,12-Dodecandiisocyanat; cycloaliphatische Diisocyanate wie Isophorondiisocyanat, 1,4-Cyclohexandiisocyanat, 1-Methyl-2,4-cyclohexandiisocyanat und 1-Methyl-2,6-cyclohexandiisocyanat sowie die entsprechenden Isomerengemische, 4,4'-Dicyclohexylmethandiisocyanat, 2,4'-Dicyclohexylmethandiisocyanat und 2,2' Dicyclohexylmethandiisocyanat sowie die entsprechenden Isomerengemische; außerdem aromatische Diisocyanate, wie 2,4-Toluylendiisocyanat, Gemische aus 2,4 Toluylendiisocyanat und 2,6 Toluylendiisocyanat, 4,4'-Diphenylmethandiisocyanat, 2,4'-Diphenylmethandiisocyanat und 2,2'-Diphenylmethandiisocyanat, Gemische aus 2,4'-Diphenylmethandiisocyanat und 4,4'-Diphenylmethandiisocyanat, urethanmodifizierte flüssige 4,4'-Diphenylmethandiisocyanate oder 2,4' Diphenylmethandiisocyanate, 4,4'-Diisocyanatodiphenylethan-(1,2) und 1,5-Naphthylendiisocyanat. Vorzugsweise verwendet werden 1,6-Hexamethylendiisocyanat, Isophorondiisocyanat, Dicyclohexylmethandiisocyanat, Diphenylmethandiisocyanat-Isomerengemische mit einem 4,4'-Diphenylmethandiisocyanatgehalt von mehr als 96 Gewichts-% und insbesondere 4,4'-Diphenylmethandiisocyanat und 1,5-Naphthylendiisocyanat.

Die genannten Diisocyanate können einzeln oder in Form von Mischungen untereinander zur Anwendung kommen. Sie können auch zusammen mit bis zu 15 mol-% (berechnet auf Gesamt-Diisocyanat) eines Polyisocyanates verwendet werden, es darf aber höchstens soviel Polyisocyanat zugesetzt werden, dass ein noch thermoplastisch verarbeitbares Produkt entsteht. Beispiele für Polyisocyanate sind Triphenylmethan-4,4',4"-triisocyanat und Polyphenyl-polymethylenpolyisocyanate.

Geeignete Katalysatoren sind die nach dem Stand der Technik bekannten und üblichen tertiären Amine, wie zum Beispiel Triethylamin, Dimethylcyclohexylamin, N-Methylmorpholin, N,N'-Dimethylpiperazin, 2-(Dimethylamino-ethoxy)ethanol, Diazabicyclo[2,2,2]octan und ähnliche Verbindungen sowie insbesondere organische Metallverbindungen wie Titansäureester, Eisenverbindungen oder Zinnverbindungen wie Zinndiacetat, Zinndioctoat, Zinndilaurat oder die Zinndialkylsalze aliphatischer Carbonsäuren wie Dibutylzinndiacetat oder Dibutylzinndilaurat oder ähnliche Verbindungen. Bevorzugte Katalysatoren sind organische Metallverbindungen, insbesondere Titansäureester, Eisen- und Zinnverbindungen. Die Gesamtmenge an Katalysatoren in den erfindungsgemäßen TPU beträgt in der Regel etwa 0 bis 5 Gewichts-%, bevorzugt 0 bis 2 Gewichts-%, bezogen auf die Gesamtmenge an TPU.

Gegenüber Isocyanaten monofunktionelle Verbindungen können in Anteilen bis zu 2 Gewichts-%, bezogen auf TPU, als sogenannte Kettenabbrecher eingesetzt werden. Geeignet sind zum Beispiel Monoamine wie Butyl- und Dibutylamin, Octylamin, Stearylamin, N-Methylstearylamin, Pyrrolidin, Piperidin oder Cyclohexylamin, Monoalkohole wie Butanol, 2-Ethylhexanol, Octanol, Dodecanol, Stearylalkohol, die verschiedenen Amylalkohole, Cyclohexanol und Ethylenglykolmonomethylether.

Die erfindungsgemäß einzusetzenden thermoplastischen Polyurethanelastomere können Hilfs- und Zusatzstoffe in Mengen bis zu maximal 20 Gewichts-%, bezogen auf die Gesamtmenge an TPU, enthalten. Typische Hilfs- und Zusatzstoffe sind Gleitmittel und Entformungsmittel wie Fettsäureester, deren Metallseifen, Fettsäureamide, Fettsäureesteramide und Siliconverbindungen, Antiblockmittel, Inhibitoren, Stabilisatoren gegen Hydrolyse, Licht, Hitze und Verfärbung, Farbstoffe, Pigmente, anorganische und/oder organische Füllstoffe, Weichmacher, wie Phosphate, Phthalate, Adipate, Sebacate und Alkylsulfonsäureester, fungistatisch und bakteriostatisch wirkende Substanzen sowie Füllstoffe und deren Mischungen und Verstärkungsmittel.

Verstärkungsmittel sind insbesondere faserartige Verstärkungsstoffe wie zum Beispiel anorganische Fasern, die nach dem Stand der Technik hergestellt werden und auch mit einer Schlichte beaufschlagt sein können. Nähere Angaben über die genannten Hilfs- und Zusatzstoffe sind der Fachliteratur, beispielsweise der Monographie von J.H. Saunders und K.C. Frisch "High Polymers", Band XVI, Polyurethane, Teil 1 und 2, Verlag Interscience Publishers 1962 bzw. 1964, dem Taschenbuch für Kunststoff-Additive von R.Gächter u. H.Müller (Hanser Verlag München 1990) oder der DE-A 29 01 774 zu entnehmen.

Zur Herstellung der erfindungsgemäßen TPU werden die Komponenten (a), (b), (c) und gegebenenfalls weitere Komponenten in solchen Mengen zur Reaktion gebracht, dass das Äquivalenzverhältnis von NCO-Gruppen der Diisocyanate (c) zur Summe der Zerewitinoff-aktiven Wasserstoffatome enthaltenden Komponenten in (a) und (b) ≥ 0,9:1 bis ≤ 1,1:1 beträgt. Dieses Verhältnis kann auch ≥ 0,95:1 bis ≤ 1,05:1 betragen.

Der Aufbau der thermoplastisch verarbeitbaren Polyurethanelastomeren kann entweder schrittweise (Prepolymerverfahren) oder durch die gleichzeitige Reaktion aller Komponenten in einer Stufe (oneshot-Verfahren) erfolgen. Beim Prepolymerverfahren wird aus dem Polyol und dem Diisocyanat ein isocyanathaltiges Prepolymer gebildet, das in einem zweiten Schritt mit dem Kettenverlängerer umgesetzt wird. Die erfindungsgemäßen thermoplastischen Polyurethane können batchweise oder kontinuierlich hergestellt werden und geformte Artikel können nach dem Spritzgieß-, Extrusions- oder Beschichtungsverfahren erhalten werden.

Ausführungsformen des erfindungsgemäßen Verfahrens werden nachfolgend beschrieben, wobei sie in beliebiger Weise kombiniert werden können, sofern sich nicht aus dem Kontext eindeutig das Gegenteil ergibt.

In einer Ausführungsform des erfindungsgemäßen Verfahrens ist das Polyol (a) ausgewählt aus der Gruppe umfassend 1,2-Polypropylenglykol-Polyether, 1,4-Butandiol-Polyether und/oder Polyesterpolyole mit 1,4-Butandiol als Alkoholkomponente. Bevorzugte Polyesterpolyole mit 1,4-Butandiol als Alkoholkomponente enthalten Adipinsäure als Säurekomponente.

In einer weiteren Ausführungsform des erfindungsgemäßen Verfahrens ist der Diol-Kettenverlängerer (b) ausgewählt aus der Gruppe umfassend 1,4-Butandiol, 1,6-Hexandiol und/oder Bis-2-hydroxyethoxy-hydrochinon.

In einer weiteren Ausführungsform des erfindungsgemäßen Verfahrens ist das organische Polyisocyanat (c) ausgewählt aus der Gruppe umfassend 4,4'-Diphenylmethandiisocyanat, Isophorondiisocyanat, Dicyclohexylmethan-4,4-diisocyanat, 1,6-Hexamethylendiisocyanat und/oder 1,5-Naphthylendiisocyanat.

In einer weiteren Ausführungsform des erfindungsgemäßen Verfahrens weist das thermoplastische Polyurethan eine Durchbruchfeldstärke von ≥ 20 V/µm bis ≤ 400 V/µm, einen elektrischen Volumenwiderstand von ≥ 10¹² Ohm cm bis ≤ 10¹⁸ Ohm cm und ein Elastizitätsmodul E' bei 50% Dehnung von ≥ 2 MPa bis ≤ 40 MPa auf. Die Durchbruchfeldstärke lässt sich hierbei gemäß ASTM D 149-97a bestimmen. Der elektrische Volumenwiderstand kann gemäß ASTM D 257 und der Elastizitätsmodul E' bei 50% Dehnung gemäß DIN 53 504 bestimmt werden. Vorzugsweise beträgt die Durchbruchfeldstärke ≥ 60 V/µm bis ≤ 300 V/µm, der elektrische Volumenwiderstand ≥ 10¹³ Ohm cm bis ≤ 10¹⁷ Ohm cm und ein Elastizitätsmodul E' bei 50% Dehnung von ≥ 3 MPa bis ≤ 30 MPa.

In einer weiteren Ausführungsform des erfindungsgemäßen Verfahrens ist die Bewegungsenergie die Bewegungsenergie von Luftströmungen oder von Wasserströmungen.

Ein weiterer Gegenstand der vorliegenden Erfindung ist die Verwendung eines thermoplastischen Polyurethans, das erhältlich ist aus der Reaktion von wenigstens:
(a) einem linearen, bifunktionellen und hydroxylterminierten Polyol mit einem zahlenmittleren Molekulargewicht Mₙ von ≥ 500 g/mol bis ≤ 6000 g/mol;
(b) einem Diol-Kettenverlängerer mit einem zahlenmittleren Molekulargewicht Mₙ von ≥ 60 g/mol bis ≤ 400 g/mol; und
(c) einem organischen Diisocyanat;
wobei das molare Verhältnis von NCO-Gruppen zu OH-Gruppen ≥ 0,9:1 bis ≤ 1,1:1 beträgt,
zur Gewinnung von elektrischer Energie aus Bewegungsenergie.

Insbesondere lässt sich das vorstehend genannte thermoplastische Polyurethan zur Gewinnung von elektrischer Energie aus Bewegungsenergie von Luftströmungen oder Wasserströmungen verwenden. Die Anwendung diese Verfahrens auf die Gewinnung von elektrischer Energie aus der Bewegungsenergie aus Meereswellen ist nicht Gegenstand dieser Erfindung.

Details zu den einzelnen Komponenten wurden bereits im Zusammenhang mit dem erfindungsgemäßen Verfahren erläutert, so dass zu Vermeidung von Wiederholungen hierauf Bezug genommen wird.

Die vorliegende Erfindung betrifft ebenfalls eine Vorrichtung zur Gewinnung von elektrischer Energie aus Bewegungsenergie, insbesondere von Luftströmungen oder Wasserströmungen,
wobei die Vorrichtung ein elektroaktives Polymer umfasst, welches zwischen Elektroden angeordnet ist;
wobei die Vorrichtung eingerichtet ist, um das elektroaktive Polymer als Folge einer mechanischen Einwirkung von einer minimalen Dehnung bis zu einer maximalen Dehnung zu dehnen und das elektroaktive Polymer als Folge einer nachlassenden mechanischen Einwirkung von der maximalen Dehnung bis zu der minimalen Dehnung zu relaxieren;
wobei die Vorrichtung eingerichtet ist, um im gedehnten Zustand des elektroaktiven Polymers dieses mit einer elektrischen Zielladung zu beaufschlagen, bei der die elektrische Durchbruchsfeldstärke des elektroaktiven Polymers nicht überschritten wird; und
wobei die Vorrichtung eingerichtet ist, um während des Relaxierens des elektroaktiven Polymers dieses bis auf eine Restladung zu entladen;
wobei
das elektroaktive Polymer ein thermoplastisches Polyurethan umfasst, das erhältlich ist aus der Reaktion von wenigstens:
(a) einem linearen, bifunktionellen und hydroxylterminierten Polyol mit einem zahlenmittleren Molekulargewicht Mₙ von ≥ 500 g/mol bis ≤ 6000 g/mol;
(b) einem Diol-Kettenverlängerer mit einem zahlenmittleren Molekulargewicht Mₙ von ≥ 60 g/mol bis ≤ 400 g/mol; und
(c) einem organischen Diisocyanat;
wobei das molare Verhältnis von NCO-Gruppen zu OH-Gruppen ≥ 0,9:1 bis ≤ 1,1:1 beträgt.

Die erfindungsgemäße Vorrichtung dient nicht zur Gewinnung von elektrischer Energie aus der Bewegungsenergie von Meereswellen. Details zu den einzelnen Komponenten wurden bereits im Zusammenhang mit dem erfindungsgemäßen Verfahren erläutert, so dass zu Vermeidung von Wiederholungen hierauf Bezug genommen wird.

In einer Ausführungsform der erfindungsgemäßen Vorrichtung ist das Polyol (a) ausgewählt aus der Gruppe umfassend 1,2-Polypropylenglykol-Polyether, 1,4-Butandiol-Polyether und/oder Polyesterpolyole mit 1,4-Butandiol als Alkoholkomponente.

In einer weiteren Ausführungsform der erfindungsgemäßen Vorrichtung ist der Diol-Kettenverlängerer (b) ausgewählt aus der Gruppe umfassend 1,4-Butandiol, 1,6-Hexandiol und/oder Bis-2-hydroxyethoxy-hydrochinon.

In einer weiteren Ausführungsform der erfindungsgemäßen Vorrichtung ist das organische Polyisocyanat (c) ausgewählt aus der Gruppe umfassend 4,4'-Diphenylmethandiisocyanat, Isophorondiisocyanat, Dicyclohexylmethan-4,4-diisocyanat, 1,6-Hexamethylendiisocyanat und/oder 1,5-Naphthylendiisocyanat.

Ein weiterer Gegenstand der vorliegenden Erfindung ist ein Aktuator und/oder Sensor, umfassend ein thermoplastisches Polyurethan, das erhältlich ist aus der Reaktion von wenigstens:
(a) einem linearen, bifunktionellen und hydroxylterminierten Polyol mit einem zahlenmittleren Molekulargewicht Mₙ von ≥ 500 g/mol bis ≤ 6000 g/mol;
(b) einem Diol-Kettenverlängerer mit einem zahlenmittleren Molekulargewicht Mₙ von ≥ 60 g/mol bis ≤ 400 g/mol; und
(c) einem organischen Diisocyanat;
wobei das molare Verhältnis von NCO-Gruppen zu OH-Gruppen ≥ 0,9:1 bis ≤ 1,1:1 beträgt.

Auch hier wird generell zur Vermeidung von Wiederholungen auf die entsprechenden Ausführungen zum erfindungsgemäßen Verfahren Bezug genommen.

Die vorliegende Erfindung wird anhand der nachfolgenden Beispiele weiter erläutert, ohne jedoch darauf beschränkt zu sein. In den Beispielen wird die Herstellung von Elastomeren beschrieben, die sich für den Einsatz im erfindungsgemäßen Verfahren eignen.

Sofern nicht abweichend gekennzeichnet, beziehen sich alle Prozentangaben auf das Gewicht und alle analytischen Messungen beziehen sich auf Temperaturen von 23 °C.

Messungen der Filmschichtdicken wurden mit einem mechanischen Taster der Firma Dr. Johannes Heidenhain GmbH, Deutschland, Dr.-Johannes-Heidenhain-Str. 5, 83301 Traunreut, durchgeführt. Die Probekörper wurden an drei unterschiedlichen Stellen vermessen und der Mittelwert als repräsentativer Messwert benutzt.

Die Zugversuche wurden mittels einer Zugmaschine der Firma Zwick, Modell Nummer 1455, ausgestattet mit einer Kraftmessdose des Gesamtmessbereiches 1 kN nach DIN 53 504 mit einer Zuggeschwindigkeit von 50 mm/min ausgeführt. Als Probekörper wurden S2-Zugstäbe eingesetzt. Jede Messung wurde an drei gleichartig präparierten Probekörpern ausgeführt und der Mittelwert der erhaltenen Daten zur Bewertung verwendet. Speziell hierfür wurden neben der Zugfestigkeit in [MPa] und der Bruchdehnung in [%] noch die Spannung in [MPa] bei 100% und 200% Dehnung bestimmt.

Die Bestimmung der bleibenden Dehnung wurde mittels einer Zugmaschine Zwicki der Firma Zwick / Roell, ausgestattet mit einer Kraftmessdose des Gesamtmessbereiches von 50N, an einem S2-Stab der zu untersuchenden Probe ausgeführt. Bei dieser Messung wird die Probe mit einer Geschwindigkeit von 50 mm / min bis zu n* 50% gedehnt, nach erreichen dieser Deformation wird die Probe auf Kraft = 0 N entlastet und die dann noch vorhandene Dehnung bestimmt. Direkt anschließend startet der nächste Messzyklus mit n = n+1; der Wert für n wird solange gesteigert, bis die Probe reißt. Hier wird nur der Wert für 50% Deformation gemessen.

Die Bestimmung des elektrischen Widerstandes geschah mittels eines Laboraufbaus der Fa. Keithley Instruments (Keithley Instruments GmbH, Landsberger Strasse 65, D-82110 Germering, Germany) Modell Nr.: 6517 A und 8009 gemäß ASTM D 257, einer Methode zur Bestimmung des Isolationswiderstandes von Werkstoffen.

Die Bestimmung der Durchbruchsfeldstärke gemäß ASTM D 149-97a wurde mit einer Hochspannungsquelle Modell hypotMAX der Firma Associated Research Inc, 13860 W Laurel Drive, Lake Forest, IL 600045-4546, USA und einem eigenkonstruierten Probenhalter durchgeführt. Der Probenhalter kontaktierte die homogen dicken Polymerproben mit nur geringer mechanische Vorbelastung und verhinderte, dass der Bediener in Kontakt mit der Spannung kommt. Die nicht vorgespannte Polymerfolie wurde in diesem Aufbau mit steigender Spannung statisch belastet, bis ein elektrischer Durchbruch durch die Folie erfolgte. Messergebnis war die beim Durchbruch erreichte Spannung, bezogen auf die Dicke der Polymerfolie in [V/µm]. Es wurden je Folie 5 Messungen ausgeführt und der Mittelwert angegeben.

### Verwendete Rohstoffe:

| | |
|---|---|
| PE 1000 | 1,4-Butandiol-Polyether mit einem Molekulargewicht von Mₙ = 1000 g/mol |
| PE 2000 | 1,4-Butandiol-Polyether mit einem Molekulargewicht von Mₙ = 2000 g/mol; |
| PES 500 | 1,4-Butandiol-adipatpolyester mit einem Molekulargewicht von Mₙ =500 g/mol |
| PES 1000 | 1,4-Butandiol-adipatpolyester mit einem Molekulargewicht von Mₙ =950 g/mol |
| PES 2250 | 1,4-Butandiol-adipatpolyester mit einem Molekulargewicht von Mₙ =2250 g/mol |
| PP 2000 | 1,2-Polypropylenglykol-Polyether mit Molekulargewicht von Mₙ = 2000 g/mol |
| MDI | Diphenylmethan-4,4'-diisocyanat |
| BUT | Butandiol-1,4 |
| HEX | Hexandiol-1,6 |
| HQEE | Bis-2-hydroxyethoxy-hydrochinon |
| Stabaxol 1 | 2,2'-6,6'-Tetraisopropyldiphenylcarbodiimid |

### Beispiel E1

100 Gewichts-Teile PE 1000 wurden mit 0,45 Gewichts-Teilen Mineralöl und 100 ppm, bezogen auf PE 1000, Zinndioctoat in einem Reaktionsgefäß auf 150 °C erwärmt.

Unter Rühren (300 U/min) wurden 55 Gewichts-Teile MDI (60°C) dazugegeben. Das entstandene Prepolymer wurde nach 1 Minute mit 22 Gewichts-Teilen HQEE unter starkem Mischen (1100 U/min) zum thermoplastischen Polyurethan (TPU) umgesetzt. Das entstandene Gemisch wurde schnell auf ein beschichtetes Blech gegossen und 30 Minuten bei 120 °C getempert. Die entstandenen Gießplatten wurden geschnitten und granuliert

### Beispiel E2

100 Gewichts-Teile PP 2000 wurden mit 1,0 Gewichts-Teilen Bis-ethylen-stearylamid und 20 ppm, bezogen auf PE 2000, Titanyl-acetylacetonat in einem Reaktionsgefäß auf 180 °C erwärmt.

Unter Rühren (300 U/min) wurden 51 Gewichts-Teile MDI (60°C) dazugegeben. Das entstandene Prepolymer wurde nach 1 Minute mit 14 Gewichts-Teilen BUT unter starkem Mischen (1100 U/min) zum TPU umgesetzt. Das entstandene Gemisch wurde schnell auf ein beschichtetes Blech gegossen und 30 Minuten bei 120 °C getempert. Die entstandenen Gießplatten wurden geschnitten und granuliert.

### Beispiel E3

100 Gewichts-Teile PE 2000 wurden mit 0,40 Gewichts-Teilen Bis-ethylen-stearylamid und 200 ppm, bezogen auf PE 2000, Zinndioctoat in einem Reaktionsgefäß auf 180 °C erwärmt.

Unter Rühren (300 U/min) wurden 12,8 Gewichts-Teile BUT zugegeben. Anschließend wurde die Mischung mit 30 Gewichts-Teilen MDI (60°C) unter starkem Mischen (1100 U/min) umgesetzt Das entstandene Gemisch wurde schnell auf ein beschichtetes Blech gegossen und 30 Minuten bei 120 °C getempert. Die entstandenen Gießplatten wurden geschnitten und granuliert

### Beispiel E4

100 Gewichts-Teile PE 1000 wurden in einem Reaktionsgefäß mit 0,8 Gewichts-Teilen Bis-ethylen-stearylamid, 22 Gewichts-Teilen BUT und 70 ppm, bezogen auf PE 1000, Zinndioctoat auf 180 °C erwärmt.

Unter starkem Rühren (1100 U/min) wurden 85 Gewichts-Teile MDI (60 °C) dazugegeben. Das entstandene Gemisch wurde schnell auf ein beschichtetes Blech gegossen und 30 Minuten bei 120 °C getempert. Die entstandenen Gießplatten wurden geschnitten und granuliert.

### Beispiel E5 : (DP 9585A DPS045)

100 Gewichts-Teile PE 1000 wurden in einem Reaktionsgefäß mit 0,15 Gewichts-Teilen Bis-ethylen-stearylamid, 10,4Gewichts-Teilen BUT, 1,2 Gewichts-Teilen HEX und 250 ppm, bezogen auf PE 1000, Zinndioctoat auf 180 °C erwärmt.

Unter starkem Rühren (1100 U/min) wurden 57 Gewichts-Teile MDI (180 °C) dazugegeben. Das entstandene Gemisch wurde schnell auf ein beschichtetes Blech gegossen und 30 Minuten bei 120 °C getempert. Die entstandenen Gießplatten wurden geschnitten und granuliert.

### Beispiel E6

100 Gewichts-Teile PES 1000 wurden in einem Reaktionsgefäß mit 0,1 Gewichts-Teilen Bis-ethylen-stearylamid, 0,6 Gewichts-Teile Stabaxol 1,17 Gewichts-Teilen BUT und 35 ppm, bezogen auf PES 1000, Zinndioctoat auf 160 °C erwärmt.

Unter starkem Rühren (1100 U/min) wurden 73 Gewichts-Teile MDI dazugegeben. Das entstandene Gemisch wurde schnell auf ein beschichtetes Blech gegossen und 30 Minuten bei 120 °C getempert. Die entstandenen Gießplatten wurden geschnitten und granuliert.

### Beispiel E7

80 Gewichts-Teile PES 1000 und 20 Gewichts-Teile PES 500 wurden in einem Reaktionsgefäß mit 14 Gewichts-Teilen BUT und 30 ppm, bezogen auf PES 1000, Titanyl-acetylacetonat auf 180 °C erwärmt.

Unter starkem Rühren (1100 U/min) wurden 70 Gewichts-Teile MDI (180 °C) dazugegeben. Das entstandene Gemisch wurde schnell auf ein beschichtetes Blech gegossen und 30 Minuten bei 120 °C getempert. Die entstandenen Gießplatten wurden geschnitten und granuliert.

### Folienverarbeitung:

Das Granulat wurde in einem Einwellen-Extruder 30/25D (Plasticorder PL 2000 6 der Firma Brabender) aufgeschmolzen (Dosierung 3 kg/h; 170-235 °C) und durch einen Flachfilmkopf zu einem Flachfilm extrudiert. An den Proben wurden der elektrische Widerstand, die Durchbruchsfeldstärke und der Modul im Zugversuch bestimmt. Die Ergebnisse sind in den nachfolgenden Tabelle 1 und 2 dargestellt.

**Tabelle 1**

| | Zugversuch | | | | |
|---|---|---|---|---|---|
| Beispiel | Max. Dehnung [%] | Spannung bei max. Dehnung [N/mm²] | E'(0%) [MPa] | E' (25%) [MPa] | E' (50%) [MPa] |
| E1 | 575,7 | 40,608 | 31,83 | 9,7068 | 4,39 |
| E2 | 606,0 | 23,500 | 20,59 | 6,7696 | 3,84 |
| E3 | 183,5 | 10,712 | 21,79 | 8,1850 | 4,96 |
| E4 | 353,5 | 43,537 | 81,10 | 10,2177 | 5,36 |
| E5 | 595,4 | 40,974 | 23,57 | 8,7336 | 2,81 |
| E6 | 314,0 | 48,923 | 59,95 | 9,684 | 3,97 |
| E7 | 391,5 | 43,300 | 36,45 | 7,7380 | 2,45 |

**Tabelle 2**

| | Bleibende Dehnung | Elektrische Leitfähigkeit | Hochspannungsfestigkeit | |
|---|---|---|---|---|
| Beispiel | Raumtemp., 50% | Volumenwiderstand [Ohm cm] | Durchbruchfeldstärke [V/µm] | Durchbruchsspannung [kV] |
| E1 | 3,06 | 2,261E+13 | 102,40 | 13,064 |
| E2 | 5,82 | 8,414E+12 | 79,24 | 14,032 |
| E3 | 3,59 | 9,2E+12 | 24,83 | 20,010 |
| E4 | 7,90 | 1,209E+14 | 95,36 | 18,616 |
| E5 | 4,01 | 1,071E+13 | 69,77 | 15,692 |
| E6 | 5,48 | 1,595E+14 | 77,1 | 17,496 |
| E7 | 7,06 | 7,53E+13 | 80,5 | 16,576 |

Es zeigte sich bei den Versuchen, dass die Polymerelemente als Filme deutliche Vorteile beim Einsatz in der Gewinnung von elektrischer Energie bieten können, da sie sehr gute Innenwiderstände, hohe Durchbruchsfeldstärken/Durchbruchsspannungen und hohe Moduli im Arbeitspunkt (zum Beispiel bei 50% Dehnung) aufweisen.

Weiterhin haben diese Werkstoffe sehr kleine bleibende Dehnungen bei hohen Bruchdehnungen. Mit diesen Polymerelementen können vorteilhaft besonders günstige Wirkungsgrade der damit hergestellten elektromechanischen Wandler bei der Energiegewinnung erzielt werden.

## Patentansprüche

1. Verfahren zur Gewinnung von elektrischer Energie aus Bewegungsenergie, umfassend die Schritte:
Bereitstellen einer Vorrichtung,
wobei die Vorrichtung ein elektroaktives Polymer umfasst, welches zwischen Elektroden angeordnet ist und
wobei in der Vorrichtung mechanische Energie auf das elektroaktive Polymer übertragen wird;
Dehnen des elektroaktiven Polymers von einer minimalen Dehnung bis zu einer maximalen Dehnung als Folge einer mechanischen Einwirkung,
wobei im gedehnten Zustand des elektroaktiven Polymers dieses mit einer elektrischen Zielladung beaufschlagt wird, bei der die elektrische Durchbruchsfeldstärke des elektroaktiven Polymers nicht überschritten wird; und
Relaxieren des gedehnten elektroaktiven Polymers von der maximalen Dehnung bis zu der minimalen Dehnung als Folge einer nachlassenden mechanischen Einwirkung,
wobei während des Relaxierens des elektroaktiven Polymers dieses bis auf eine Restladung entladen wird;
**dadurch gekennzeichnet, dass**
das elektroaktive Polymer ein thermoplastisches Polyurethan umfasst, das erhältlich ist aus der Reaktion von wenigstens:
(a) einem linearen, bifunktionellen und hydroxylterminierten Polyol mit einem zahlenmittleren Molekulargewicht Mₙ von ≥ 500 g/mol bis ≤ 6000 g/mol;
(b) einem Diol-Kettenverlängerer mit einem zahlenmittleren Molekulargewicht Mₙ von ≥ 60 g/mol bis ≤ 400 g/mol; und
(c) einem oder mehreren organischen Diisocyanaten;
wobei das molare Verhältnis von NCO-Gruppen in (c) zu OH-Gruppen in (a) und (b) ≥ 0,9:1 bis ≤ 1,1:1 beträgt.

2. Verfahren nach Anspruch 1,
**dadurch gekennzeichnet, dass**
das Polyol (a) ausgewählt ist aus der Gruppe umfassend 1,2-Polypropylenglykol-Polyether, 1,4-Butandiol-Polyether und/oder Polyesterpolyole mit 1,4-Butandiol als Alkoholkomponente.

3. Verfahren nach Anspruch 1 oder 2,
**dadurch gekennzeichnet, dass**
der Diol-Kettenverlängerer (b) ausgewählt ist aus der Gruppe umfassend 1,4-Butandiol, 1,6-Hexandiol und/oder Bis-2-hydroxyethoxy-hydrochinon.

4. Verfahren nach einem der Ansprüche 1 bis 3,
**dadurch gekennzeichnet, dass**
das organische Polyisocyanat (c) ausgewählt ist aus der Gruppe umfassend 4,4'-Diphenylmethandiisocyanat, Isophorondiisocyanat, Dicyclohexylmethan-4,4-diisocyanat, 1,6-Hexamethylendiisocyanat und/oder 1,5-Naphthylendiisocyanat.

5. Verfahren nach einem der Ansprüche 1 bis 4,
**dadurch gekennzeichnet, dass**
das thermoplastische Polyurethan eine Durchbruchfeldstärke von ≥ 20 V/µm bis ≤ 400 V/µm, einen elektrischen Volumenwiderstand von ≥ 10¹² Ohm cm bis ≤ 10¹⁸ Ohm cm und ein Elastizitätsmodul E' bei 50% Dehnung von ≥ 2 MPa bis ≤ 40 MPa aufweist.

6. Verfahren nach einem der Ansprüche 1 bis 5,
**dadurch gekennzeichnet, dass**
die Bewegungsenergie die Bewegungsenergie von Luftströmungen ist.

7. Verfahren nach einem der Ansprüche 1 bis 5,
**dadurch gekennzeichnet, dass**
die Bewegungsenergie die Bewegungsenergie von Wasserströmungen ist.

8. Verwendung eines thermoplastischen Polyurethans, das erhältlich ist aus der Reaktion von wenigstens:
(a) einem linearen, bifunktionellen und hydroxylterminierten Polyol mit einem zahlenmittleren Molekulargewicht Mₙ von ≥ 500 g/mol bis ≤ 6000 g/mol;
(b) einem Diol-Kettenverlängerer mit einem zahlenmittleren Molekulargewicht Mₙ von ≥ 60 g/mol bis ≤ 400 g/mol; und
(c) einem organischen Diisocyanat;
wobei das molare Verhältnis von NCO-Gruppen zu OH-Gruppen ≥ 0,9:1 bis ≤ 1,1:1 beträgt,
zur Gewinnung von elektrischer Energie aus Bewegungsenergie, als Aktuatormaterial und/oder als Sensormaterial.

9. Vorrichtung zur Gewinnung von elektrischer Energie aus Bewegungsenergie, insbesondere aus Luftströmungen oder Wasserströmungen,
wobei die Vorrichtung ein elektroaktives Polymer umfasst, welches zwischen Elektroden angeordnet ist;
wobei die Vorrichtung eingerichtet ist, um das elektroaktive Polymer als Folge einer mechanischen Einwirkung von einer minimalen Dehnung bis zu einer maximalen Dehnung zu dehnen und das elektroaktive Polymer als Folge einer nachlassenden mechanischen Einwirkung von der maximalen Dehnung bis zu der minimalen Dehnung zu relaxieren;
wobei die Vorrichtung eingerichtet ist, um im gedehnten Zustand des elektroaktiven Polymers dieses mit einer elektrischen Zielladung zu beaufschlagen, bei der die elektrische Durchbruchsfeldstärke des elektroaktiven Polymers nicht überschritten wird; und
wobei die Vorrichtung eingerichtet ist, um während des Relaxierens des elektroaktiven Polymers dieses bis auf eine Restladung zu entladen;
**dadurch gekennzeichnet, dass**
das elektroaktive Polymer ein thermoplastisches Polyurethan umfasst, das erhältlich ist aus der Reaktion von wenigstens:
(a) einem linearen, bifunktionellen und hydroxylterminierten Polyol mit einem zahlenmittleren Molekulargewicht Mₙ von ≥ 500 g/mol bis ≤ 6000 g/mol;
(b) einem Diol-Kettenverlängerer mit einem zahlenmittleren Molekulargewicht Mₙ von ≥ 60 g/mol bis ≤ 400 g/mol; und
(c) einem organischen Diisocyanat;
wobei das molare Verhältnis von NCO-Gruppen zu OH-Gruppen ≥ 0,9:1 bis ≤ 1,1:1 beträgt.

10. Vorrichtung nach Anspruch 9,
**dadurch gekennzeichnet, dass**
das Polyol (a) ausgewählt ist aus der Gruppe umfassend 1,2-Polypropylenglykol-Polyether, 1,4-Butandiol-Polyether und/oder Polyesterpolyole mit 1,4-Butandiol als Alkoholkomponente.

11. Vorrichtung nach Anspruch 9 oder 10,
**dadurch gekennzeichnet, dass**
der Diol-Kettenverlängerer (b) ausgewählt ist aus der Gruppe umfassend 1,4-Butandiol, 1,6-Hexandiol und/oder Bis-2-hydroxyethoxy-hydrochinon.

12. Vorrichtung nach einem der Ansprüche 9 bis 11,
**dadurch gekennzeichnet, dass**
das organische Polyisocyanat (c) ausgewählt ist aus der Gruppe umfassend 4,4'-Diphenylmethandiisocyanat, Isophorondiisocyanat, Dicyclohexylmethan-4, 4-diisocyanat, 1,6-Hexamethylendiisocyanat und/oder 1,5-Naphthylendiisocyanat.

13. Aktuator und/oder Sensor, umfassend ein thermoplastisches Polyurethan, das erhältlich ist aus der Reaktion von wenigstens:
(a) einem linearen, bifunktionellen und hydroxylterminierten Polyol mit einem zahlenmittleren Molekulargewicht Mₙ von ≥ 500 g/mol bis ≤ 6000 g/mol;
(b) einem Diol-Kettenverlängerer mit einem zahlenmittleren Molekulargewicht Mₙ von ≥ 60 g/mol bis ≤ 400 g/mol; und
(c) einem organischen Diisocyanat;
wobei das molare Verhältnis von NCO-Gruppen zu OH-Gruppen ≥ 0,9:1 bis ≤ 1,1:1 beträgt.
